(19) Europäisches Patentamt
European Patent Office
Office européen des brevets

(11) **EP 3 100 600 B1**

(12) **EUROPÄISCHE PATENTSCHRIFT**

(45) Veröffentlichungstag und Bekanntmachung des Hinweises auf die Patenterteilung:
**12.02.2020 Patentblatt 2020/07**

(21) Anmeldenummer: **14715225.0**

(22) Anmeldetag: **20.03.2014**

(51) Int Cl.:
*H05K 7/20* (2006.01)    *H01L 23/40* (2006.01)
*H01L 25/11* (2006.01)

(86) Internationale Anmeldenummer:
**PCT/EP2014/055623**

(87) Internationale Veröffentlichungsnummer:
**WO 2015/139754 (24.09.2015 Gazette 2015/38)**

(54) **ELEKTRISCHES MODUL MIT SPANNEINRICHTUNG**

ELECTRIC MODULE COMPRISING A TENSIONING DEVICE

MODULE ÉLECTRIQUE COMPRENANT UN SYSTÈME DE SERRAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**07.12.2016 Patentblatt 2016/49**

(73) Patentinhaber: **Siemens Aktiengesellschaft**
**80333 München (DE)**

(72) Erfinder:
• **SCHMITT, Daniel**
  **90459 Nürnberg (DE)**
• **ZENKNER, Andreas**
  **90587 Obermichelbach (DE)**

(56) Entgegenhaltungen:
EP-A1- 0 015 578        FR-A1- 2 550 887
FR-A1- 2 977 949        JP-A- H08 264 981
US-A1- 2010 039 770     US-B1- 6 677 673

• "INFLATABLE INTERNAL COMPUTER STRUCTURE", IBM TECHNICAL DISCLOSURE BULLETIN, INTERNATIONAL BUSINESS MACHINES CORP. (THORNWOOD), US, Bd. 39, Nr. 1, 1. Januar 1996 (1996-01-01) , Seiten 309-312, XP000556414, ISSN: 0018-8689

## Beschreibung

Die Erfindung bezieht sich auf elektrische Module mit elektrischen Bauelementen, insbesondere Bauelementstapeln, bei denen zum Verspannen eine Spannkraft erzeugt wird.

Elektrische Module mit Bauelementstapeln sind beispielsweise auf dem Gebiet der Multilevelumrichter bekannt. Multilevelumrichter sind zum Beispiel in dem Konferenzbeitrag "An Innovative Modular Multilevel Converter Topology Suitable for a Wide Power Range" (Anton Lesnicar und Rainer Marquardt, 2003 IEEE Bologna Power Tech Conference, June 23th-26th, Bologna, Italy), beschrieben.

Aus der JP H08 264981 A ist eine elektronische Einrichtung mit mehreren Komponenten bekannt, bei der zur Vermeidung von Vibrationen der Komponenten zwischen den Komponenten eine Kühlplatte angeordnet ist, die im Betrieb der Einrichtung ihr Volumen ausweitet und dadurch einen Druck auf die Komponenten ausübt.

Die Druckschrift US 2010/0039770 A1 offenbart eine weitere elektrische Einrichtung, bei der zwischen die Komponenten der Einrichtung ein aufblasbares Kissen eingesetzt ist. Durch eine Volumenerweiterung des Kissens, kann dieses eine Druckkraft auf die anliegenden Komponenten ausüben, die dadurch einen verbesserten Kontakt zu ihnen zugeordneten Kühlmodulen aufweisen.

Im Beitrag "Inflatable Internal Computer Structure", IBM Technical Disclosure Bulletin, vom Januar 1996, ist eine Stützstruktur für Bauteile eines tragbaren Rechners offenbart. Die Stützstruktur umfasst ein aufblasbares Kissen, das dazu vorgesehen ist, eine Leiterplatte innerhalb der Stützstruktur räumlich zu fixieren.

Eine weitere Kühlvorrichtung zur Kühlung elektronischer Komponenten mit volumenerweiterbaren Kühlelementen ist aus der FR 2 977 949 A1 bekannt.

Um bei aufeinandergestapelten Bauelementen bzw. bei Bauelementstapeln die zum mechanischen Verspannen erforderlichen Spannkräfte zu erzeugen, werden heutzutage Gewindesysteme in Kombination mit Tellerfedern oder anderen Federelementen eingesetzt, die eine mechanische Kraft in das mechanische System einleiten. Die Spannkrafteinbringung erfolgt in der Regel jedoch sehr punktuell mit einem oder mehreren Schraubelementen über Druckstücke, so dass sich eine großflächige homogene Verteilung der Spannkraft nicht immer erreichen lässt. Gerade für sehr große Halbleiterelemente ist es mit den bekannten punktuellen Gewindemechaniken sehr schwierig, eine homogene Spannkraftverteilung über die gesamte Halbleiterfläche zu realisieren.

Der Erfindung liegt demgemäß die Aufgabe zugrunde, ein elektrisches Modul anzugeben, bei dem sich eine Spannkraft zum Verspannen des Moduls mit sehr geringem Aufwand sowie sehr homogen über der Modulfläche erzeugen lässt.

Diese Aufgabe wird erfindungsgemäß durch ein elektrisches Modul mit den Merkmalen gemäß Patentanspruch 1 gelöst. Vorteilhafte Ausgestaltungen des erfindungsgemäßen Moduls sind in Unteransprüchen angegeben.

Danach ist erfindungsgemäß vorgesehen, dass das elektrische Modul zumindest einen mit einem Medium, insbesondere einem Fluid, gefüllten oder füllbaren Hohlkörper aufweist, der eine von seinem im Inneren des Hohlkörpers herrschenden Innendruck abhängige Druckkraft auf mindestens ein Bauelement des Moduls ausübt.

Ein wesentlicher Vorteil des erfindungsgemäßen Moduls besteht darin, dass eine homogene Druckkraft zum Verspannen des Moduls mit sehr geringem Aufwand erzeugt werden kann; es reicht aus, den Hohlkörper zu füllen und dessen Innendruck zu erhöhen. Der dadurch erzeugte Druck ist über die die gesamte Querschnittsfläche des Hohlkörpers zumindest annähernd homogen.

Besonders kostengünstig ist es, wenn der Hohlkörper durch eine Blase oder einen Ballon gebildet ist, dessen Größe druckabhängig ist. Der Hohlkörper ist vorzugsweise dehnbar und besteht bevorzugt aus einem elastisch deformierbaren Material (z. B. Kunststoff oder Gummi); alternativ kann die Hülle des Hohlkörpers auch aus einem wenig oder gar nicht dehnbaren Material bestehen, wie beispielsweise einer Metallfolie.

Mit Blick auf eine homogene Druckkraftverteilung im Inneren des Moduls wird es als vorteilhaft angesehen, wenn die Größe der Querschnittsfläche des Hohlkörpers - im Querschnitt quer zur Längsrichtung des Moduls gesehen - der Querschnittsfläche des Bauelements entspricht.

Um eine Doppelfunktion des Hohlkörpers zu erreichen, nämlich zum einen die Funktion einer Druckkrafterzeugung und zum anderen die Funktion einer Federung, wird es als vorteilhaft angesehen, wenn das Medium komprimierbar ist. Vorzugsweise handelt es sich bei dem Medium um ein Gas, insbesondere um Luft. Mit anderen Worten ist es also vorteilhaft, wenn der Hohlkörper eine Gasdruckfeder bildet, die als Bestandteil einer das Modul verspannenden Spanneinrichtung eine Federkraft auf das mindestens eine Bauelement des Moduls ausübt.

Das Modul weist erfindungsgemäß mindestens einen Bauelementstapel auf, der zwei oder mehr Bauelemente enthält. Der Hohlkörper bildet dabei einen Bestandteil einer Spanneinrichtung bildet, die den Bauelementstapel zusammendrückt.

Weist das Modul zwei oder mehr Hohlkörper auf, so ist es vorteilhaft, wenn die Hohlkörper druckmäßig miteinander in Verbindung stehen. Eine druckmäßige Verbindung vereinfacht zum einen das Befüllen der Hohlkörper; zum anderen wird durch die druckmäßige Verbindung die Bildung eines modulübergreifenden Druckfederspannsystems erreicht, das das Modul modulübergreifend federnd verspannt.

Bezüglich der Anordnung der Hohlkörper ist zumindest einer der Hohlkörper erfindungsgemäß außerhalb des Bauelementstapels angeordnet und übt von außen eine Druckkraft auf den Bauelementstapel aus. Vorzugsweise ist der außerhalb des Bauelementstapels angeordnete Hohlkörper in einem ein Widerlager bildenden Aufnahmebehälter angeordnet, der in Richtung des Bauelementstapels eine Behälteröffnung aufweist, durch die der Hohlkörper seine Druckkraft auf den Bauelementstapel ausübt.

Als besonders vorteilhaft wird es angesehen, wenn das Modul zumindest zwei Hohlkörper aufweist, nämlich einen ersten Hohlkörper, der an einem ersten Stapelende des Bauelementstapels angeordnet ist und von außen eine Druckkraft auf das erste Stapelende ausübt, und einen zweiten Hohlkörper, der an einem zweiten Stapelende des Bauelementstapels angeordnet ist und von außen eine Druckkraft auf das zweite Stapelende ausübt.

Bei der letztgenannten Variante ist es besonders vorteilhaft, wenn der erste außerhalb des Bauelementstapels angeordnete Hohlkörper in einem ein erstes Widerlager bildenden ersten Aufnahmebehälter angeordnet ist, der eine dem ersten Stapelende des Bauelementstapels zugewandte Behälteröffnung aufweist, durch die der erste Hohlkörper seine Druckkraft auf das erste Stapelende des Bauelementstapels ausübt, und der zweite außerhalb des Bauelementstapels angeordnete Hohlkörper in einem ein zweites Widerlager bildenden zweiten Aufnahmebehälter angeordnet ist, der eine dem zweiten Stapelende des Bauelementstapels zugewandte Behälteröffnung aufweist, durch die der zweite Hohlkörper seine Druckkraft auf das zweite Stapelende des Bauelementstapels ausübt.

Mit Blick auf eine optimale Federung der Bauelemente des Bauelementstapels, insbesondere im Falle einer internen Explosion von Bauelementen des Moduls, wird es als vorteilhaft angesehen, wenn zumindest einer der Hohlkörper im Inneren des Bauelementstapels liegt, den Bauelementstapel unter Bildung von Stapelsegmenten segmentiert und eine von seinem Innendruck abhängige Druckkraft auf die an ihm anliegenden Stapelsegmente ausübt.

Als Bauelemente weist der Bauelementstapel vorzugsweise Halbleiterbauelemente, insbesondere Halbleiterschaltelemente und/oder Gleichrichtelemente, Kühlkörper und/oder Anschlusselektroden auf.

Die Erfindung bezieht sich darüber hinaus auf ein Verfahren zum Verspannen eines mindestens ein Bauelement aufweisenden elektrischen Moduls.

Mit Blick auf das Erzeugen einer möglichst homogenen Spannkraft wird es als vorteilhaft angesehen, wenn zumindest ein Hohlkörper einer Spanneinrichtung des Moduls mit einem Fluid befüllt wird, bis der Hohlkörper mittelbar oder unmittelbar eine vorgegebene Mindestdruckkraft auf das Bauelement ausübt.

Bezüglich der Vorteile des erfindungsgemäßen Verfahrens sei auf die obigen Ausführungen im Zusammenhang mit dem erfindungsgemäßen Modul verwiesen, da die Vorteile des erfindungsgemäßen Moduls denen des erfindungsgemäßen Verfahrens im Wesentlichen entsprechen.

Die Erfindung wird nachfolgend anhand von Ausführungsbeispielen näher erläutert; dabei zeigen beispielhaft

Figur 1     ein Ausführungsbeispiel für ein elektrisches Modul, bei dem eine Spanneinrichtung zwei gasgefüllte Hohlkörper umfasst, wobei in der Figur 1 die Hohlkörper bei einem mittleren Gasdruck gezeigt sind,

Figur 2     das elektrische Modul gemäß Figur 1, nachdem der Gasdruck in den Hohlkörpern erhöht worden ist,

Figur 3     ein Ausführungsbeispiel für ein elektrisches Modul, bei dem eine Spanneinrichtung einen einzigen gasgefüllten Hohlkörper zum Verspannen des Moduls aufweist, wobei die Figur 3 den Hohlkörper bei einem mittleren Gasdruck zeigt,

Figur 4     das elektrische Modul gemäß Figur 3, nachdem der Gasdruck des Hohlkörpers erhöht worden ist,

Figur 5     ein Ausführungsbeispiel für ein elektrisches Modul, bei dem eine Spanneinrichtung zwei äußere gasgefüllte Hohlkörper sowie zusätzlich einen innenliegenden gasgefüllten Hohlkörper aufweist, wobei die Figur 5 einen mittleren Gasdruck der drei Hohlkörper zeigt,

Figur 6     das elektrische Modul gemäß Figur 5, nachdem der Gasdruck in den drei Hohlkörpern erhöht worden ist, und

Figur 7     das Verhalten des elektrischen Moduls gemäß Figur 6 im Falle eines elektrischen Fehlers und einer im Inneren des Moduls auftretenden Explosion.

In den Figuren werden der Übersicht halber für identische oder vergleichbare Komponenten stets dieselben Bezugszeichen verwendet.

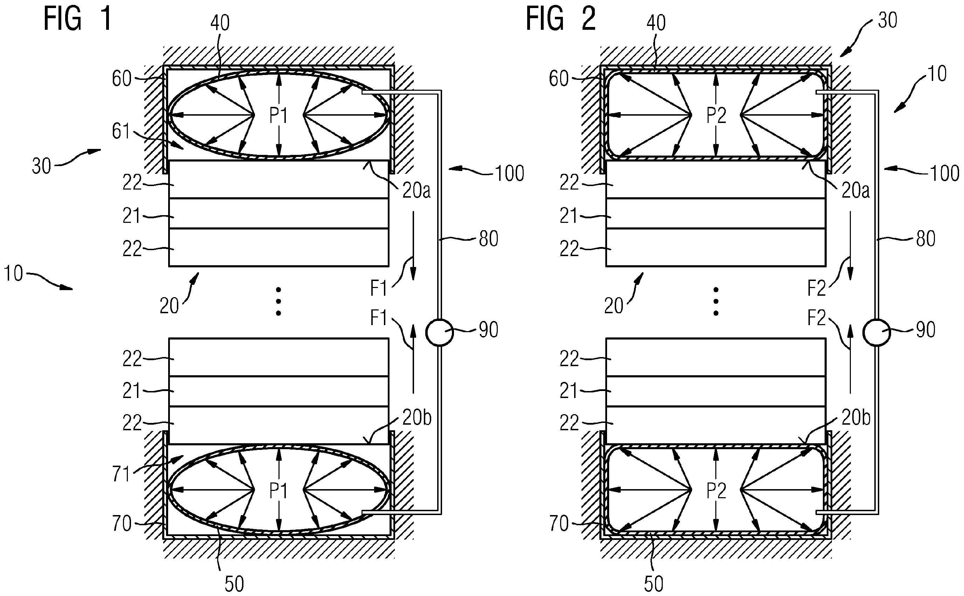

Die Figur 1 zeigt ein elektrisches Modul 10, das mit einem Bauelementstapel 20 ausgestattet ist. Der Bauelementstapel 20 besteht aus einer Vielzahl an Bauelementen, von denen in der Figur 1 Halbleiterbauelemente und Kühlkörper mit den Bezugszeichen 21 und 22 gekennzeichnet sind. Zum Zusammendrücken der Bauelemente des Bauelementstapels 20 ist das elektrische Modul 10 mit einer Spanneinrichtung 30 ausgestattet, die einen Spannverband bildet.

Die Spanneinrichtung 30 weist einen ersten dehnbaren Hohlkörper 40 und einen zweiten dehnbaren Hohlkörper 50 auf. Die beiden dehnbaren Hohlkörper 40 und 50 können beispielsweise durch Blasen oder dehnbare Ballons gebildet sein.

Der erste, in der Figur 1 obere Hohlkörper 40 ist in einem ersten Aufnahmebehälter 60 gehalten, der ortsfest gelagert ist und ein Widerlager für den Hohlkörper 40 bildet. Der erste Aufnahmebehälter 60 weist eine Behälteröffnung 61 auf, durch die der Hohlkörper 40 auf ein in der Figur 1 oberes Stapelende 20a - nachfolgend erstes Stapelende genannt - des Bauelementstapels 20 eine Druckkraft ausüben kann.

Der zweite Hohlkörper 50 befindet sich in einem zweiten Aufnahmebehälter 70, der ebenfalls ortsfest gelagert ist und ein Widerlager für den zweiten Hohlkörper 50 bildet. Durch eine Behälteröffnung 71 des Aufnahmebehälters 70 steht der zweite Hohlkörper 50 mit einem in der Figur 1 unteren bzw. zweiten Stapelende 20b des Bauelementstapels 20 in Verbindung.

Die beiden Hohlkörper 40 und 50 sind über eine Druckleitung 80 druckmäßig gekoppelt und können über ein Ventil 90 mit einem Medium, beispielsweise einem komprimierbaren Medium wie Luft, gefüllt werden. Die beiden Hohlkörper 40 und 50, die Druckleitung 80 und das Ventil 90 bilden ein nach außen gasdichtes und - aufgrund der Druckleitung 80 - druckgekoppeltes Druckfederspannsystem 100 der Spanneinrichtung 30 bzw. des elektrischen Moduls 10.

Die Figur 1 zeigt die beiden Hohlkörper 40 und 50 bei einem mittleren Gasdruck P1, bei dem die beiden Hohlkörper 40 und 50 zwar an den beiden Stapelenden 20a und 20b des Bauelementstapels 20 aufliegen, jedoch nur eine kleine Druckkraft F1 auf den Bauelementstapel 20 ausüben.

Um den Bauelementstapel 20 zusammenzupressen bzw. das Modul 10 zu verspannen, wird das Druckfederspannsystem 100 über das Ventil 90 mit Gas gefüllt und der Innendruck in den beiden Hohlkörpern 40 und 50 erhöht. Durch das Erhöhen des Innendrucks dehnen sich die beiden Hohlkörper 40 und 50 aus, wie in der Figur 2 dargestellt ist. Man erkennt, dass die beiden Hohlkörper 40 und 50 die zugeordneten Aufnahmebehälter 60 und 70 vollständig ausfüllen und der Anpressdruck gegen die beiden Stapelenden 20a und 20b des Bauelementstapels 20 signifikant erhöht wird. Die Druckkraft auf die beiden Stapelenden 20a und 20b ist in der Figur 2 mit dem Bezugszeichen F2 gekennzeichnet.

Durch die Druckerhöhung im Inneren der beiden Hohlkörper 40 und 50 wird eine Spannkraft erzeugt, durch die die Bauelemente des Bauelementstapels 20 zusammengedrückt werden und der elektrische Kontaktwiderstand zwischen den Bauelementen des Bauelementstapels 20 reduziert wird.

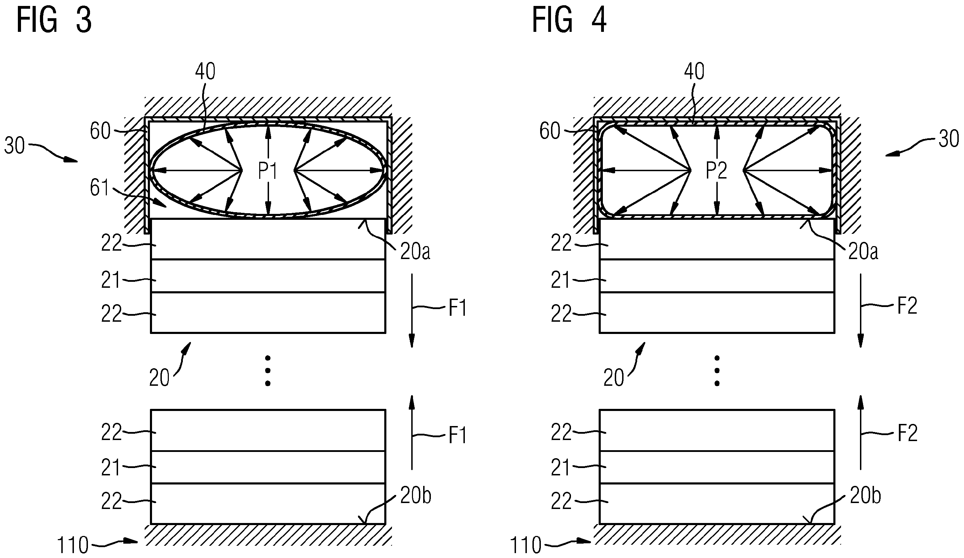

Die Figur 3 zeigt ein Ausführungsbeispiel für ein elektrisches Modul 10, dessen Bauelementstapel 20 dem Bauelementstapel des elektrischen Moduls 10 gemäß den Figuren 1 und 2 entsprechen kann. Demgemäß weist auch der Bauelementstapel 20 gemäß Figur 3 Halbleiterbauelemente 21 und Kühlkörper 22 auf.

Zum Verspannen des Bauelementstapels 20 ist bei dem elektrischen Modul 10 eine Spanneinrichtung 30 vorgesehen, die lediglich einen einzigen dehnbaren Hohlkörper 40 umfasst. Der Hohlkörper 40 ist in einem ein Widerlager bildenden Aufnahmebehälter 60 gehalten, durch dessen Behälteröffnung 61 der Hohlkörper 40 auf dem in der Figur 3 oberen Stapelende 20a des Bauelementstapels 20 aufliegt.

Das zweite, in der Figur 3 untere Stapelende 20b des Bauelementstapels 20 liegt auf einem ortsfesten Widerlager 110 auf.

Die Figur 3 zeigt das elektrische Modul 10 bei einem mittleren Gasdruck im Inneren des Hohlkörpers 40. Es lässt sich erkennen, dass der Hohlkörper 40 zwar an dem ersten Stapelende 20a des Bauelementstapels 20 aufliegt, jedoch die Anpresskraft durch den Hohlkörper 40 noch gering ist. Die Anpresskraft zw. Druckkraft ist in der Figur 3 mit dem Bezugszeichen F1 gekennzeichnet.

Die Figur 4 zeigt das elektrische Modul 10, nachdem der Gasdruck im Inneren des Hohlkörpers 40 erhöht worden ist, so dass der Hohlkörper 40 den zugeordneten Aufnahmebehälter 60 vollständig füllt und über die Behälteröffnung 61 eine signifikante Druckkraft F2 auf den Bauelementstapel 20 ausübt. Es gilt also:

$$F2 \gg F1.$$

Durch das Befüllen des Hohlkörpers 40 und das Erzeugen der Druckkraft F2 werden die Bauelemente des Bauelementstapels 20 zusammengedrückt, so dass der elektrische Kontaktwiderstand zwischen den Bauelementen des Bauelementstapels 20 minimiert wird.

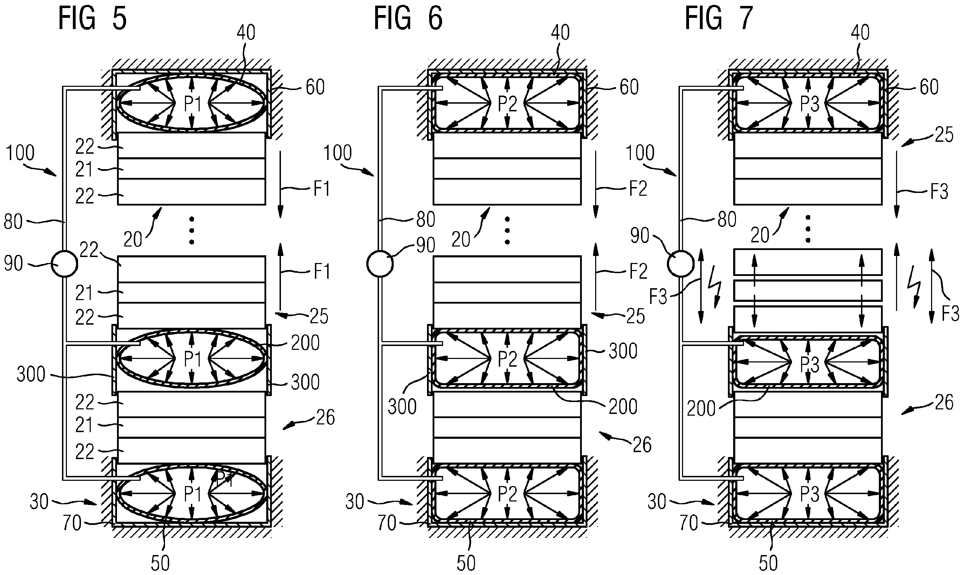

Die Figur 5 zeigt ein Ausführungsbeispiel für ein elektrisches Modul, bei dem ein Bauelementstapel 20 eine Vielzahl an Halbleiterbauelementen 21 sowie eine Vielzahl an Kühlkörpern 22 aufweist. Zum Verspannen des Bauelementstapels 20 bzw. zum Verspannen des Moduls 10 ist eine Spanneinrichtung 30 vorhanden, die zwei äußere dehnbare Hohlkörper 40 und 50 sowie einen im Inneren des Bauelementstapels 20 bzw. innenliegenden Hohlkörper 200 aufweist. Die beiden äußeren Hohlkörper 40 und 50 sind in Aufnahmebehältern 60 und 70 gehalten, die jeweils Widerlager für die Spanneinrichtung 30 bilden. Die Hohlkörper 40 und 50 sowie die Aufnahmebehälter 60 und 70 können den Hohlkörpern und Aufnahmebehältern gemäß den Figuren 1 und 2 entsprechen, so dass diesbezüglich auf die obigen Ausführungen verwiesen sei.

Die beiden Hohlkörper 40 und 50 sowie der innenliegende Hohlkörper 200 stehen über eine Druckleitung 80 druckmäßig miteinander in Verbindung und können über ein Ventil 90 mit Gas gefüllt werden. Die drei Hohlkörper 40, 50 und 200, die Druckleitung 80 sowie das Ventil 90 bilden ein nach außen gasdichtes und - aufgrund der Druckleitung 80 - druckgekoppeltes Druckfederspannsystem 100, mit dem sich der Bauelementstapel 20 zusammendrücken bzw. verspannen lässt.

Durch den innenliegenden Hohlkörper 200 wird der Bauelementstapel 20 in zwei Stapelsegmente 25 und 26 unterteilt. Die Stapelsegmente 25 und 26 können durch den innenliegenden Hohlkörper 200 elektrisch voneinander isoliert werden. Alternativ ist es möglich, die beiden Stapelsegmente 25 und 26 elektrisch miteinander zu verbinden und hierfür leitende Platten vorzusehen, mit denen die elektrische Verbindung hergestellt wird. Derartige elektrische Platten sind in der Figur 5 beispielhaft angedeutet und mit Bezugszeichen 300 markiert. Die Platten 300 können im Übrigen nicht nur eine elektrische Funktion zum Verbinden der Stapelsegmente 25 und 26 ausüben, sondern darüber hinaus auch eine seitliche Begrenzung für den Hohlkörper 200 bilden, durch den die seitliche Ausdehnung des Hohlkörpers 200 senkrecht zur Längsrichtung des Bauelementstapels 20 im Falle einer Druckerhöhung verhindert wird.

Die Figur 5 zeigt das Druckfederspannsystem 100 bzw. die drei Hohlkörper 40, 50 und 200 bei einem mittleren Gasdruck P1, bei dem der Bauelementstapel 20 mit einer nur geringen Druckkraft F1 zusammengedrückt wird.

Die Figur 6 zeigt das elektrische Modul 10 gemäß Figur 5, nachdem durch ein Erhöhen des Drucks P2 im Inneren der drei Hohlkörper 40, 50 und 200 die auf den Bauelementstapel 20 wirkende Druckkraft signifikant erhöht worden ist. Die erhöhte Druckkraft ist in der Figur 6 mit dem Bezugszeichen F2 gekennzeichnet. Es gilt also:

$$F2 \gg F1 \text{ und } P2 \gg P1.$$

Durch die Druckerhöhung im Inneren der Hohlkörper 40, 50 und 200 und durch das Erhöhen der Druckkraft auf den Bauelementstapel 20 werden die Bauelemente des Bauelementstapels 20 zusammengepresst, so dass der Kontaktwiderstand zwischen den Bauelementen minimiert wird.

Die Figur 7 zeigt die Arbeitsweise bzw. Funktionsweise der drei Hohlkörper 40, 50 und 200 im Falle eines Versagens einer oder mehrerer der Bauelemente des Bauelementstapels 20 und einer auftretenden Explosion. Die durch die Explosion auftretende Druckwelle, die in der Figur 7 durch einen Druck P3 und eine Druckkraft F3 symbolisiert wird, wird von den Hohlkörpern 40, 50 und 200, die druckmäßig miteinander verbunden sind, ganz oder zumindest zum Teil absorbiert. Die Hohlkörper 40, 50 und 200 arbeiten sozusagen als Schockarbsorber, durch die die auf die übrigen, nicht explodierten und noch funktionsfähigen Bauelemente des Bauelementstapels 20 wirkenden mechanischen Kräfte gemildert bzw. reduziert werden. Eine mechanische Zerstörung der übrigen, nicht explodierten Bauelemente des Bauelementstapels 20 kann somit durch die als Gasdruckfedern arbeitenden Hohlkörper 40, 50 und 200 des Druckfederspannsystems 100 in vorteilhafter Weise vermieden werden, gleichzeitig bleibt der Spannverband steif genug und öffnet sich auch während eines Fehlerevents nicht bzw. nicht signifikant.

Keine Spaltbildung bedeutet auch keine Lichtbogenbildung. Folgeschäden werden weitestgehend verhindert.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Bezugszeichenliste

| 10 | elektrisches Modul |
|---|---|
| 20 | Bauelementstapel |
| 20a | erstes Stapelende |
| 20b | zweites Stapelende |
| 21 | Halbleiterbauelement |
| 22 | Kühlkörper |
| 25 | Stapelsegment |
| 26 | Stapelsegment |
| 30 | Spanneinrichtung |
| 40 | erster Hohlkörper |
| 50 | zweiter Hohlkörper |
| 60 | erster Aufnahmebehälter |
| 61 | Behälteröffnung |
| 70 | zweiter Aufnahmebehälter |
| 71 | Behälteröffnung |
| 80 | Druckleitung |
| 90 | Ventil |
| 100 | Druckfederspannsystem |
| 110 | Widerlager |
| 200 | innenliegender Hohlkörper |
| 300 | elektrische Platte |
| F1 | Druckkraft/Anpresskraft |
| F2 | Druckkraft/Anpresskraft |
| F3 | Druckkraft/Anpresskraft |
| P1 | Gasdruck |
| P2 | Gasdruck |
| P3 | Gasdruck |

**Patentansprüche**

1. Elektrisches Modul (10) mit mindestens einem elektrischen Bauelement (21, 22), das elektrische Modul (10) zumindest einen mit einem Medium, insbesondere einem Fluid, gefüllten oder füllbaren Hohlkörper (40, 50, 200) aufweist, der eine von seinem im Inneren des Hohlkörpers (40, 50, 200) herrschenden Innendruck abhängige Druckkraft auf das mindestens eine Bauelement (21, 22) des Moduls (10) ausübt,
**dadurch gekennzeichnet, dass**

- das Modul (10) mindestens einen Bauelementstapel (20) aufweist, der zwei oder mehr Bauelemente (21, 22) enthält, und
- der Hohlkörper (40, 50, 200) einen Bestandteil einer Spanneinrichtung (30) bildet, die den Bauelementstapel (20) zusammendrückt, wobei
- der mindestens eine Hohlkörper (40, 50) oder zumindest einer der Hohlkörper (40, 50) des Moduls (10) außerhalb des Bauelementstapels(20) angeordnet ist und von außen eine Druckkraft auf den Bauelementstapel (20) ausübt.

2. Modul (10) nach Anspruch 1,
**dadurch gekennzeichnet, dass** der Hohlkörper (40, 50, 200) durch eine Blase oder einen Ballon gebildet ist, dessen Größe druckabhängig ist.

3. Modul (10) nach einem der voranstehenden Ansprüche,
**dadurch gekennzeichnet, dass** die Größe der Querschnittsfläche des Hohlkörpers (40, 50, 200) im Querschnitt quer zur Längsrichtung des Moduls (10) der Querschnittsfläche des Bauelements entspricht.

4. Modul (10) nach einem der voranstehenden Ansprüche,
**dadurch gekennzeichnet, dass**

- das Medium komprimierbar ist und durch ein Gas, insbesondere Luft, gebildet ist und
- der Hohlkörper (40, 50, 200) eine Gasdruckfeder bildet, die als Bestandteil einer das Modul (10) verspannenden Spanneinrichtung (30) eine Federkraft auf das mindestens eine Bauelement (21, 22) des Moduls (10) ausübt.

5. Modul (10) nach einem der voranstehenden Ansprüche,
**dadurch gekennzeichnet, dass** das Modul (10) zwei oder mehr Hohlkörper (40, 50, 200) aufweist, die druckmäßig miteinander in Verbindung stehen.

6. Modul (10) nach Anspruch 5,
**dadurch gekennzeichnet, dass** die zwei oder mehr druckmäßig miteinander in Verbindung stehenden Hohlkörper (40, 50, 200) ein druckdichtes Druckfederspannsystem (100) bilden, das das Modul (10) federnd verspannt.

7. Modul (10) nach einem der vorangehenden Ansprüche,
**dadurch gekennzeichnet, dass** der außerhalb des Bauelementstapels (20) angeordnete Hohlkörper (40, 50) in einem ein Widerlager bildenden Aufnahmebehälter (60, 70) angeordnet ist, der in Richtung des Bauelementstapels (20) eine Behälteröffnung (61, 71) aufweist, durch die der Hohlkörper (40, 50) seine Druckkraft auf den Bauelementstapel (20) ausübt.

8. Modul (10) nach einem der voranstehenden Ansprüche,
**dadurch gekennzeichnet, dass**

- das Modul (10) einen ersten Hohlkörper (40, 50) aufweist, der an einem ersten Stapelende (20a) des Bauelementstapels (20) angeordnet ist und von außen eine Druckkraft auf das erste Stapelende (20a) ausübt, und
- das Modul (10) einen zweiten Hohlkörper (40, 50) aufweist, der an einem zweiten Stapelende (20b) des Bauelementstapels (20) angeordnet ist und von außen eine Druckkraft auf das zweite Stapelende (20b) ausübt.

9. Modul (10) nach Anspruch 8,
**dadurch gekennzeichnet, dass**

- der erste außerhalb des Bauelementstapels (20) angeordnete Hohlkörper (40, 50) in einem ein erstes Widerlager bildenden ersten Aufnahmebehälter (60, 70) angeordnet ist, der eine dem ersten Stapelende (20a) des Bauelementstapels (20) zugewandte Behälteröffnung (61, 71) aufweist, durch die der erste Hohlkörper (40, 50) seine Druckkraft auf das erste Stapelende (20a) des Bauelementstapels (20) ausübt, und
- der zweite außerhalb des Bauelementstapels (20) angeordnete Hohlkörper (40, 50) in einem ein zweites Widerlager bildenden zweiten Aufnahmebehälter (60, 70) angeordnet ist, der eine dem zweiten Stapelende (20b) des Bauelementstapels (20) zugewandte Behälteröffnung (61, 71) aufweist, durch die der zweite Hohlkörper (40, 50) seine Druckkraft auf das zweite Stapelende (20b) des Bauelementstapels (20) ausübt.

10. Modul (10) nach einem der voranstehenden Ansprüche,
**dadurch gekennzeichnet, dass** der mindestens eine Hohlkörper (40, 50, 200) oder zumindest einer der Hohlkörper (40, 50, 200) des Moduls (10) im Inneren des Bauelementstapels (20) liegt, den Bauelementstapel (20) unter Bildung von Stapelsegmenten segmentiert und eine von seinem Innendruck abhängige Druckkraft auf die an ihm anliegenden Stapelsegmente ausübt.

11. Modul (10) nach einem der voranstehenden Ansprüche,
**dadurch gekennzeichnet, dass** der Bauelementstapel (20) als Bauelemente Halbleiterbauelemente (21), insbesondere Halbleiterschaltelemente und/oder Gleichrichtelemente, Kühlkörper (22) und/oder Anschlusselektroden aufweist.

12. Verfahren zum Verspannen eines mindestens ein Bauelement (21, 22) aufweisenden elektrischen Moduls (10) nach Anspruch 1, **dadurch gekennzeichnet, dass** zumindest ein Hohlkörper (40, 50, 200) einer Spanneinrichtung (30) des Moduls (10) mit einem Fluid befüllt wird, bis der Hohlkörper (40, 50, 200) mittelbar oder unmittelbar eine vorgegebene Mindestdruckkraft auf das Bauelement (21, 22) ausübt.

## Claims

1. Electrical module (10) having at least one electrical component (21, 22), the electrical module (10) comprises at least one hollow body (40, 50, 200) that is filled or can be filled with a medium, in particular a fluid, and that exerts a pressing force on the at least one component (21, 22) of the module (10), said pressing force being dependent upon its internal pressure that is prevailing in the interior of the hollow body (40, 50, 200), **characterized in that**

   - the module (10) comprises at least one component stack (20) that comprises two or more components (21, 22), and
   - the hollow body (40, 50, 200) forms a component of a clamping device (30) that presses the component stack (20) together, wherein
   - the at least one hollow body (40, 50) or at least one of the hollow bodies (40, 50) of the module (10) is arranged outside the component stack (20) and exerts from outside a pressing force on the component stack (20).

2. Module (10) according to Claim 1, **characterized in that** the hollow body (40, 50, 200) is formed by a bladder or a balloon the size of which is dependent upon the pressure.

3. Module (10) according to any one of the preceding claims, **characterized in that** the size of the cross-sectional area of the hollow body (40, 50, 200) corresponds in the cross-section in a transverse manner with respect to the longitudinal direction of the module (10) of the cross-sectional area of the component.

4. Module (10) according to any one of the preceding claims, **characterized in that**

   - the medium can be compressed and is formed by means of a gas, in particular air, and
   - the hollow body (40, 50, 200) forms a gas pressure spring, that as a component of a clamping device (30) that clamps the module (10) exerts a resilient force on the at least one component (21, 22) of the module (10).

5. Module (10) according to any one of the preceding claims, **characterized in that** the module (10) comprises two or more hollow bodies (40, 50, 200) that are connected to one another in terms of pressure.

6. Module (10) according to Claim 5, **characterized in that** the two or more hollow bodies (40, 50, 200) that are connected to one another in terms of pressure form a pressure-tight pressure spring clamping system (100) that clamps the module (10) in a resilient manner.

7. Module (10) according to any one of the preceding claims,, **characterized in that** the hollow body (40, 50) that is arranged outside the component stack (20) is arranged in a receiving container (60, 70) that forms a counter bearing and said receiving container comprises a container aperture (61, 71) in the direction towards the component stack (20) by means of which the hollow body (40, 50) exerts its pressing force on the component stack (20) .

8. Module (10) according to any one of the preceding claims, **characterized in that**

   - the module (10) comprises a first hollow body (40, 50) that is arranged on a first stack end (20a) of the component stack (20) and exerts from outside a pressing force on the first stack end (20a), and
   - the module (10) comprises a second hollow body (40, 50) that is arranged on a second stack end (20b) of the component stack (20) and exerts from outside a pressing force on the second stack end (20b).

9. Module (10) according to Claim 8, **characterized in that**

   - the first hollow body (40, 50) that is arranged outside the component stack (20) is arranged in a first receiving container (60, 70) that forms a first counter bearing and said first receiving container comprises a container aperture (61, 71) that faces the first stack end (20a) of the component stack (20) and by means of said container aperture the first hollow body (40, 50) exerts its pressing force on the first stack end (20a) of the component stack (20),
and
- the second hollow body (40, 50) that is arranged outside the component stack (20) is arranged in a second receiving container (60, 70) that forms a second counter bearing and said second receiving container comprises a container aperture (61, 71) that faces the second stack end (20b) of the component stack (20) and by means of said container aperture the second hollow body (40, 50) exerts its pressing force on the second stack end (20b) of the component stack (20).

10. Module (10) according to any one of the preceding claims,
**characterized in that**
the at least one hollow body (40, 50, 200) or at least one of the hollow bodies (40, 50, 200) of the module (10) lies in the interior of the component stack (20), divides the component stack (20) to form stack segments and exerts a pressing force dependent on its internal pressure on the stack segments that lie against said component stack.

11. Module (10) according to any one of the preceding claims,
**characterized in that**
the component stack (20) comprises as components semiconductor components (21), in particular semiconductor switching elements and/or rectifier elements, cooling bodies (22) and/or connection electrodes.

12. Method for clamping an electrical module (10) according to Claim 1 that comprises at least one component (21, 22),
**characterized in that**
at least one hollow body (40, 50, 200) of a clamping device (30) of the module (10) is filled with a fluid until the hollow body (40, 50, 200) exerts a predetermined minimum pressing force directly or indirectly on the component (21, 22) .

**Revendications**

1. Module (10) électrique, comprenant au moins un composant (21, 22) électrique,
le module (10) électrique a au moins un corps (40, 50, 200) creux, rempli ou pouvant l'être d'un milieu, notamment d'un fluide, qui applique au au moins un composant (21, 22) du module (10) une force de pression dépendant de sa pression intérieure régnant à l'intérieur du corps (40, 50, 200) creux,

**caractérisé en ce que**

- le module (10) a au moins un empilement (20) de composants, qui comporte deux composants (21, 22) ou plus de deux composants (21, 22), et
- le corps (40, 50, 200) creux forme une partie constitutive d'un dispositif (30) de serrage, qui comprime ensemble l'empilement (20) de composants, dans lequel
- le au moins un corps (40, 50) creux ou au moins l'un des corps (40, 50) creux du module (10) est disposé à l'extérieur de l'empilement (20) de composants et applique, de l'extérieur, une force de pression à l'empilement (20) de composants.

2. Module (10) suivant la revendication 1,
**caractérisé en ce que**
le corps (40, 50, 200) creux est formé d'une vessie ou d'un ballon, dont la dimension dépend de la pression.

3. Module (10) suivant l'une des revendications précédentes,
**caractérisé en ce que**
la dimension de la surface de section transversale du corps (40, 50, 200) creux correspond, en section transversale transversalement à la direction longitudinale du module (10), à la surface de section transversale du composant.

4. Module (10) suivant l'une des revendications précédentes,
**caractérisé en ce que**

- le milieu peut être comprimé et est formé d'un gaz, notamment d'air et
- le corps (40, 50, 200) creux forme un ressort à pression de gaz, qui, en tant que partie constitutive d'un dispositif (30) de serrage serrant le module (10), applique une force de ressort au au moins un composant (21, 22) du module (10).

5. Module (10) suivant l'une des revendications précédentes,
**caractérisé en ce que**
le module (10) a deux corps (40, 50, 200) creux ou plus de deux corps (40, 5, 200) creux, qui communiquent entre eux en pression.

6. Module (10) suivant la revendication 5,
**caractérisé en ce que**
les deux corps (40, 50, 200) creux ou les plus de deux corps (40, 50, 200) creux, communiquant entre eux en pression, forment un système (100) de serrage par ressort de compression étanche à la pression, qui serre élastiquement le module (10).

**7.** Module (10) suivant l'une des revendications précédentes,
**caractérisé en ce que**
le corps (40, 50) creux, disposé à l'extérieur de l'empilement (20) de composants, est disposé dans un récipient (60, 70) de réception, qui forme une butée et qui a, dans la direction de l'empilement (20) de composants, une ouverture (61, 71), par laquelle le corps (40, 50) creux applique sa force de pression sur l'empilement (20) de composants.

**8.** Module (10) suivant l'une des revendications précédentes,
**caractérisé en ce que**

- le module (10) a un premier corps (40, 50) creux, qui est disposé à une première extrémité (20a) de l'empilement (20) de composants, et qui applique de l'extérieur une force de pression à la première extrémité (20a) de l'empilement, et
- le module (10) a un deuxième corps (40, 50) creux, qui est disposé à une deuxième extrémité (20b) de l'empilement (20) de composants et qui applique de l'extérieur une force de pression à la deuxième extrémité (20b) de l'empilement.

**9.** Module (10) suivant la revendication 8,
**caractérisé en ce que**

- le premier corps (40, 50) creux, disposé à l'extérieur de l'empilement (20) de composants, est disposé dans un premier récipient (60, 70) de réception, qui forme une première butée et qui a une ouverture (61, 71) tournée vers la première extrémité (20a) de l'empilement (20) de composants, ouverture par laquelle le premier corps (40, 50) creux applique sa force de pression à la première extrémité (20a) de l'empilement (20) de composants, et
- le deuxième corps (40, 50) creux, disposé à l'extérieur de l'empilement (20) de composants, est disposé dans un deuxième récipient (60, 70) de réception, qui forme une deuxième butée et qui a une ouverture (61, 71) tournée vers la deuxième extrémité (20b) de l'empilement (20) de composants, ouverture par laquelle le deuxième corps (40, 50) creux applique sa force de pression à la deuxième extrémité (20b) de l'empilement (20) de composants.

**10.** Module (10) suivant l'une des revendications précédentes,
**caractérisé en ce que**
le au moins un corps (40, 5, 200) creux ou au moins l'un des corps (40, 50, 200) creux du module (10) se trouve à l'intérieur de l'empilement (20) de composants, segmente l'empilement (20) de composants en formant des segments d'empilement et applique une force de pression, qui dépend de sa pression intérieure, aux segments d'empilement s'y appliquant.

**11.** Module (10) suivant l'une des revendications précédentes,
**caractérisé en ce que**
l'empilement (20) de composants a comme composants des composants (21) à semi-conducteur, notamment des éléments de commutation à semi-conducteur et/ou des éléments redresseurs, des puits (22) de chaleur et/ou des électrodes de connexion.

**12.** Procédé de serrage d'au moins un module (10) électrique ayant un composant (21, 22) suivant la revendication 1,
**caractérisé en ce que**
l'on remplit d'un fluide au moins un corps (40, 50, 200) creux d'un dispositif (30) de serrage du module (10) jusqu'à ce que le corps (40, 50, 200) creux applique au composant (21, 22), indirectement ou directement, une force de pression minimum donnée à l'avance.

FIG 1   FIG 2

EP 3 100 600 B1

FIG 3

FIG 4

FIG 5

40

60

P1

22
21
22

100

F1

80

20

90

22

F1

21

22

25

200

P1

300

300

22

21

22

26

P1  P1

30

70

50

FIG 6

40

60

P2

100

F2

80

90

20

F2

25

P2

300

300

200

26

P2

30

70

50

FIG 7

40

60

P3

100

25

F3

80

90

20

F3

F3

P3

200

26

25

F3

P3

30

70

50

EP 3 100 600 B1

**EP 3 100 600 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP H08264981 A
- US 20100039770 A1

- FR 2977949 A1

**In der Beschreibung aufgeführte Nicht-Patentliteratur**

- **ANTON LESNICAR ; RAINER MARQUARDT.** An Innovative Modular Multilevel Converter Topology Suitable for a Wide Power Range. *IEEE Bologna Power Tech Conference,* 23. Juni 2003

- Inflatable Internal Computer Structure. *IBM Technical Disclosure Bulletin,* Januar 1996